# EUROPEAN PATENT APPLICATION

(11) **EP 4 797 539 A1**
(43) Date of publication of application: **26.08.2026**
(21) Application number: 24887783.9
(22) Date of filing: 28.10.2024
(51) Int. Cl.: H03M 7/30, G06F 17/16, H04L 1/00

(54) **DATA COMPRESSION METHOD AND COMMUNICATION APPARATUS**

(30) Priority: 08.11.2023 CN 202311485019
(71) Applicant: HUAWEI TECHNOLOGIES CO., LTD., Shenzhen 518129 (CN)
(72) Inventor: DU, Yuqing, Shenzhen, Guangdong 518129 (CN); MA, Mengyao, Shenzhen, Guangdong 518129 (CN); XIE, Junwen, Shenzhen, Guangdong 518129 (CN); YAN, Min, Shenzhen, Guangdong 518129 (CN)
(74) Representative: Körber, Martin Hans
(86) International application number: PCT/CN2024/127623
(87) International publication number: WO 2025/098170

(57) **Abstract**

This application provides a data compression method and a communication apparatus. The method includes: A communication apparatus determines, based on first data, a first initial basis vector and a first data space corresponding to the first initial basis vector. The communication apparatus determines first basis information based on second data that is in the first data and that belongs to the first data space. The communication apparatus performs data compression on the second data by using the first basis information, to obtain first compressed data. The communication apparatus sends first information, where the first information indicates the first basis information and the first compressed data. Data compression complexity can be reduced, and compression efficiency can be improved.

## Description

This application claims priority to Chinese Patent Application No. 202311485019.5, filed with the China National Intellectual Property Administration on November 8, 2023 and entitled "DATA COMPRESSION METHOD AND COMMUNICATION APPARATUS", which is incorporated herein by reference in its entirety.

### TECHNICAL FIELD

This application relates to the communication field, and more specifically, to a data compression method and a communication apparatus.

### BACKGROUND

In communication systems, data is typically compressed and quantized before being transmitted, to reduce data transmission costs. As the communication systems evolve toward wider bandwidth and higher throughputs, an amount of data to be transmitted by communication devices becomes increasingly massive. While maintaining compression performance, there is also a need to improve compression efficiency and reduce compression costs and overheads.

### SUMMARY

Embodiments of this application provide a data compression method and a communication apparatus, to reduce data compression complexity, improve compression efficiency, and reduce power consumption of the apparatus.

According to a first aspect, a data compression method is provided. The method may be performed by a communication apparatus. The communication apparatus may be a communication device (for example, a terminal or a network device), or the communication apparatus may be a module (for example, a chip or a chip system) configured in (or used in) a communication device. The following uses an example in which a first communication apparatus performs the method for description.

The method includes: The first communication apparatus determines, based on first data, a first initial basis vector and a first data space corresponding to the first initial basis vector. The first communication apparatus determines first basis information based on second data that is in the first data and that belongs to the first data space. The first communication apparatus performs data compression on the second data by using the first basis information, to obtain first compressed data. The first communication apparatus sends first information, where the first information indicates the first basis information and the first compressed data.

According to the foregoing solution, the first communication apparatus may perform data space division on the to-be-transmitted data, and determine, based on data included in each data space, corresponding basis information for data compression. Compared with inferring basis information based on high-dimensional data through dictionary learning, this can avoid performing a large quantity of times of SVD decomposition, and reduce execution of a high-complexity algorithm. Data compression efficiency can be improved, and power consumption of the apparatus can be reduced.

With reference to the first aspect, in some implementations of the first aspect, that the first communication apparatus determines, based on the first data, the first initial basis vector includes: The first communication apparatus determines first initial basis information based on the first data, where a plurality of basis vectors indicated by the first initial basis information include the first initial basis vector. That the first communication apparatus obtains the first basis information based on the second data includes: The first communication apparatus adjusts the first initial basis information based on the second data, to obtain the first basis information.

For example, a representation coefficient of the second data with respect to the first basis information, is sparser than a representation coefficient of the second data with respect to the first initial basis information.

According to the foregoing solution, the first communication apparatus may specifically first determine, based on the first data, one piece of initial basis information and a corresponding data space, and then adjust the initial basis information based on data in the data space to obtain the first basis information. In a process of determining the initial basis information, a small quantity of times of SVD decomposition may need to be performed, or SVD decomposition may not be performed at all. Other processing (for example, determining the data space and adjusting the first initial basis information) is mainly performed through a low-complexity algorithm like matrix rotation processing and calculation of a distance from a data point to a spatial line. Therefore, complexity of data compression can be reduced, data compression efficiency can be improved, and power consumption of the apparatus can be reduced.

With reference to the first aspect, in some implementations of the first aspect, the first information further indicates a first spatial offset, and the first spatial offset is a spatial offset corresponding to the first data space.

With reference to the first aspect, in some implementations of the first aspect, that the first communication apparatus performs data compression on the second data by using the first basis information, to obtain the first compressed data includes: The first communication apparatus compresses, by using the first basis information, data obtained by processing the second data based on the first spatial offset, to obtain the first compressed data.

According to the foregoing solution, the first spatial offset is specifically a spatial offset of a principal axis line of the first data space, and the second data is located in the first data space. Therefore, the second data may be compressed after the first spatial offset is removed, which can further reduce an amount of compressed data.

With reference to the first aspect, in some implementations of the first aspect, the method further includes: The first communication apparatus determines, based on third data, a second initial basis vector and a second data space corresponding to the second initial basis vector, where the third data is data other than the second data in the first data. The first communication apparatus determines second basis information based on fourth data that is in the third data and that belongs to the second data space. The first communication apparatus performs data compression on the fourth data by using the second basis information, to obtain second compressed data. The first communication apparatus sends second information, where the second information indicates the second basis information and the second compressed data; or the second information indicates the second basis information, the second compressed data, and a second spatial offset, and the second spatial offset is a spatial offset corresponding to the second initial basis vector.

According to the foregoing solution, for remaining data other than the second data in the first data, data space division may continue to be performed, and corresponding basis information is determined based on data in a space. Low-complexity data compression can be implemented.

With reference to the first aspect, in some implementations of the first aspect, that the second information indicates the second basis information includes: The second information includes differential information between the second basis information and the first basis information.

For example, the differential information includes angle information, and the angle information indicates an angular difference between the second basis information and reference basis information.

According to the foregoing solution, the second information may use the first basis information as a reference to indicate the differential information between the second basis information and the first basis information, so that signaling overheads can be reduced, and resource utilization can be improved.

Implementation 1-1: That the first communication apparatus determines, based on the third data, the second initial basis vector includes: determining second initial basis information based on the third data, where a plurality of basis vectors indicated by the second initial basis information include the second initial basis vector. Obtaining the second basis information based on the fourth data includes: The first communication apparatus adjusts the second initial basis information based on the fourth data, to obtain the second basis information.

For example, a representation coefficient of data in the fourth data with respect to the second basis information is sparser than a representation coefficient of the data in the fourth data with respect to the second initial basis information.

According to the foregoing solution, for data other than the second data in the first data, a manner of processing the first data may still be used, to implement low-complexity data compression.

Implementation 1-2: That the first communication apparatus determines, based on the third data, the second initial basis information includes: The first communication apparatus adjusts reference basis information based on a target space determined based on the third data, to obtain the second initial basis information.

For example, the reference basis information includes the first basis information, or the reference basis information is predefined.

Optionally, if the reference basis information is determined from a plurality of pieces of predefined candidate basis information, the first information further indicates the reference basis information.

According to the foregoing solution, for the remaining data (that is, the third data) other than the second data in the first data, the reference basis information may be adjusted based on the target space to which the third data belongs, to obtain corresponding initial basis information. This implementation of adjusting the reference basis information is mainly achieved by adjusting a matrix angle. Compared with the implementation 1-1, this implementation can further reduce implementation complexity.

Implementation 2: The first communication apparatus determines, based on third data and the first basis information, maximum differential information between basis information. The first communication apparatus determines, based on the maximum differential information and division precision, a plurality of data spaces and a plurality of pieces of basis information corresponding to the plurality of data spaces. The first communication apparatus sends third information, where the third information indicates the maximum differential information, and one piece of basis information among the plurality of pieces of basis information corresponds to one data space among the plurality of data spaces, and the one piece of basis information is used to compress data that is in the third data and that belongs to the one data space.

According to the foregoing solution, this implementation can further reduce implementation complexity compared with the implementation 1-2. After obtaining the maximum differential information, the first communication apparatus may determine, based on the maximum differential information and the division precision, a data space and a basis vector that correspond to all the remaining data without a need for iterative processing.

With reference to the first aspect, in some implementations of the first aspect, the third information further indicates the division precision, or the division precision is predefined.

With reference to the first aspect, in some implementations of the first aspect, the plurality of data spaces include M data spaces, where M is a positive integer. The M data spaces each include the data in the third data. The third information further includes compressed data obtained by separately compressing data in corresponding data spaces based on M pieces of basis information corresponding to the M data spaces.

With reference to the first aspect, in some implementations of the first aspect, the third information further indicates a data space that is in the plurality of data spaces and that includes and/or does not include data in the third data.

According to the foregoing solution, because a data space that does not include data may exist in the plurality of data spaces, if one data space does not include data, the third information does not include compressed data corresponding to the data space. Therefore, the third information may indicate a data space that is in the plurality of data spaces and that includes and/or does not include the data in the third data, so that a second communication apparatus may determine a data space corresponding to each piece of compressed data in the third information, and decompress the compressed data by using basis information corresponding to the corresponding data space. This can reduce data transmission errors caused by a failure to reach a consensus.

According to a second aspect, a communication apparatus is provided. In a design, the apparatus may include modules that one-to-one correspond to the method/operations/steps/actions described in any one of the first aspect or the implementations of the first aspect. The modules may be implemented by a hardware circuit, software, or a combination of the hardware circuit and the software. In a design, the apparatus includes a processing unit, configured to determine, based on first data, a first initial basis vector and a first data space corresponding to the first initial basis vector, where the processing unit is further configured to determine first basis information based on second data that is in the first data and that belongs to the first data space; and the processing unit is further configured to perform data compression on the second data by using the first basis information, to obtain first compressed data; and a transceiver unit, configured to send first information, where the first information indicates the first basis information and the first compressed data.

With reference to the second aspect, in some implementations of the second aspect, the processing unit is specifically configured to determine first initial basis information based on the first data, where a plurality of basis vectors indicated by the first initial basis information include the first initial basis vector. The processing unit is specifically configured to adjust the first initial basis information based on the second data, to obtain the first basis information.

With reference to the second aspect, in some implementations of the second aspect, a representation coefficient of the second data with respect to the first basis information, is sparser than a representation coefficient of the second data with respect to the first initial basis information.

With reference to the second aspect, in some implementations of the second aspect, the first information further indicates a first spatial offset, and the first spatial offset is a spatial offset corresponding to the first data space.

With reference to the second aspect, in some implementations of the second aspect, the processing unit is specifically configured to compress, by using the first basis information, data obtained by processing the second data based on the first spatial offset, to obtain the first compressed data.

With reference to the second aspect, in some implementations of the second aspect, the processing unit is further configured to determine, based on third data, a second initial basis vector and a second data space corresponding to the second initial basis vector, where the third data is data other than the second data in the first data. The processing unit is further configured to determine second basis information based on fourth data that is in the third data and that belongs to the second data space. The processing unit is further configured to perform data compression on the fourth data by using the second basis information, to obtain second compressed data. The transceiver unit is further configured to send second information, where the second information indicates the second basis information and the second compressed data; or the second information indicates the second basis information, the second compressed data, and a second spatial offset, and the second spatial offset is a spatial offset corresponding to the second initial basis vector.

With reference to the second aspect, in some implementations of the second aspect, the processing unit is specifically configured to determine second initial basis information based on the third data, where a plurality of basis vectors indicated by the second initial basis information include the second initial basis vector. The processing unit is specifically configured to adjust the second initial basis information based on the fourth data, to obtain the second basis information.

With reference to the second aspect, in some implementations of the second aspect, a representation coefficient of data in the fourth data with respect to the second basis information is sparser than a representation coefficient of the data in the fourth data with respect to the second initial basis information.

With reference to the second aspect, in some implementations of the second aspect, the processing unit is specifically configured to adjust reference basis information based on a target space determined based on the third data, to obtain the second initial basis information.

With reference to the second aspect, in some implementations of the second aspect, the processing unit is further configured to determine, based on third data and the first basis information, maximum differential information between basis information. The processing unit is further configured to determine, based on the maximum differential information and division precision, a plurality of data spaces and a plurality of pieces of basis information corresponding to the plurality of data spaces. The transceiver unit is further configured to send third information, where the third information indicates the maximum differential information, and one piece of basis information among the plurality of pieces of basis information corresponds to one data space among the plurality of data spaces, and the one piece of basis information is used to compress data that is in the third data and that belongs to the one data space.

With reference to the second aspect, in some implementations of the second aspect, the third information further indicates a data space that is in the plurality of data spaces and that includes and/or does not include data in the third data.

According to a third aspect, a communication apparatus is provided, including a processor. The processor may implement the method according to any one of the first aspect and the possible implementations of the first aspect. Optionally, the communication apparatus further includes a memory. The processor is coupled to the memory, and may be configured to execute instructions in the memory, to implement the method according to any one of the first aspect or the possible implementations of the first aspect. Optionally, the communication apparatus further includes a communication interface, and the processor is coupled to the communication interface. In embodiments of this application, the communication interface may be a transceiver, a pin, a circuit, a bus, a module, or a communication interface of another type. This is not limited.

In an implementation, the communication apparatus is a communication device (for example, a terminal device or an access network device). When the communication apparatus is the communication device, the communication interface may be a transceiver or an input/output interface.

In another implementation, the communication apparatus is a chip configured in the communication device. When the communication apparatus is the chip configured in the communication device, the communication interface may be an input/output interface.

Optionally, the transceiver may be a transceiver circuit. Optionally, the input/output interface may be an input/output circuit.

According to a fourth aspect, a processor is provided, including an input circuit, an output circuit, and a processing circuit. The processing circuit is configured to: receive a signal through the input circuit, and transmit the signal through the output circuit, to cause the processor to perform the method according to any one of the first aspect and the possible implementations of the first aspect.

In a specific implementation process, the processor may be one or more chips, the input circuit may be an input pin, the output circuit may be an output pin, and the processing circuit may be a transistor, a gate circuit, a trigger, any logic circuit, or the like. An input signal received by the input circuit may be received and input by, for example, but not limited to, a receiver, a signal output by the output circuit may be output to, for example, but not limited to, a transmitter and transmitted by the transmitter, and the input circuit and the output circuit may be a same circuit, where the circuit is used as the input circuit and the output circuit at different moments. Specific implementations of the processor and the various circuits are not limited in embodiments of this application.

According to a fifth aspect, a computer program product is provided. The computer program product includes a computer program (which may also be referred to as code or instructions). When the computer program is run, a computer is caused to perform the method according to any one of the first aspect and the possible implementations of the first aspect.

According to a sixth aspect, a computer-readable storage medium is provided. The computer-readable storage medium stores a computer program (which may also be referred to as code or instructions). When the computer program is run on a computer, the computer is caused to perform the method according to any one of the first aspect and the possible implementations of the first aspect.

According to a seventh aspect, a communication system is provided, including the foregoing at least one first network device and the foregoing at least one second access network device. Optionally, the communication system further includes the foregoing at least one terminal device.

### BRIEF DESCRIPTION OF DRAWINGS

FIG. 1 is a diagram of a communication system to which an embodiment of this application is applicable;
FIG. 2 is a diagram of a data compression method based on dictionary learning according to this application;
FIG. 3 is a schematic flowchart of a data compression method according to an embodiment of this application;
FIG. 4 is a diagram of a first linear space according to an embodiment of this application;
FIG. 5 is a schematic flowchart of an implementation 1-1 according to an embodiment of this application;
FIG. 6 is a diagram of a rotation angle of a basis matrix according to an embodiment of this application;
FIG. 7 is a diagram of a data space according to an embodiment of this application;
FIG. 8 is a schematic flowchart of an implementation 1-2 according to an embodiment of this application;
FIG. 9 is a diagram of a data envelope according to an embodiment of this application;
FIG. 10 is a schematic flowchart of an implementation 2 according to an embodiment of this application;
FIG. 11 is a diagram of a structure of a communication apparatus according to an embodiment of this application; and
FIG. 12 is a diagram of another structure of a communication apparatus according to an embodiment of this application.

### DESCRIPTION OF EMBODIMENTS

The following describes technical solutions of this application with reference to accompanying drawings.

In embodiments of this application, a character "/" may indicate an "or" relationship between associated objects. For example, A/B may indicate A or B. A term "and/or" may be used to describe three relationships that exist between the associated objects. For example, A and/or B may indicate the following three cases: Only A exists, both A and B exist, and only B exists, where A and B may be singular or plural. For ease of description of technical solutions in embodiments of this application, in embodiments of this application, terms such as "first" and "second" may be used for differentiation. The terms such as "first" and "second" do not limit a quantity and an execution sequence, and the terms such as "first" and "second" do not limit a definite difference. In embodiments of this application, the term like "example" or "for example" is used to represent an example, an illustration, or a description. Any embodiment or design scheme described as an "example" or "for example" shall not be explained as being more preferred or having more advantages than another embodiment or design scheme. The term like "example" or "for example" is used to present a related concept in a specific manner for ease of understanding. In embodiments of this application, "at least one (type)" may alternatively be described as "one (type) or more (types)", and "a plurality of (types)" may be two (types), three (types), four (types), or more (types). This is not limited in this application.

The technical solutions in embodiments of this application may be applied to various communication systems, for example, a long term evolution (long term evolution, LTE) system, a 5th generation (5th generation, 5G) communication system, a wireless fidelity (wireless fidelity, Wi-Fi) system. A communication method provided in this application may be further applied to a communication system that is evolved after 5G, for example, a 6th generation (6th generation, 6G) communication system, a future communication system, another communication system, or the like. This is not limited in this application.

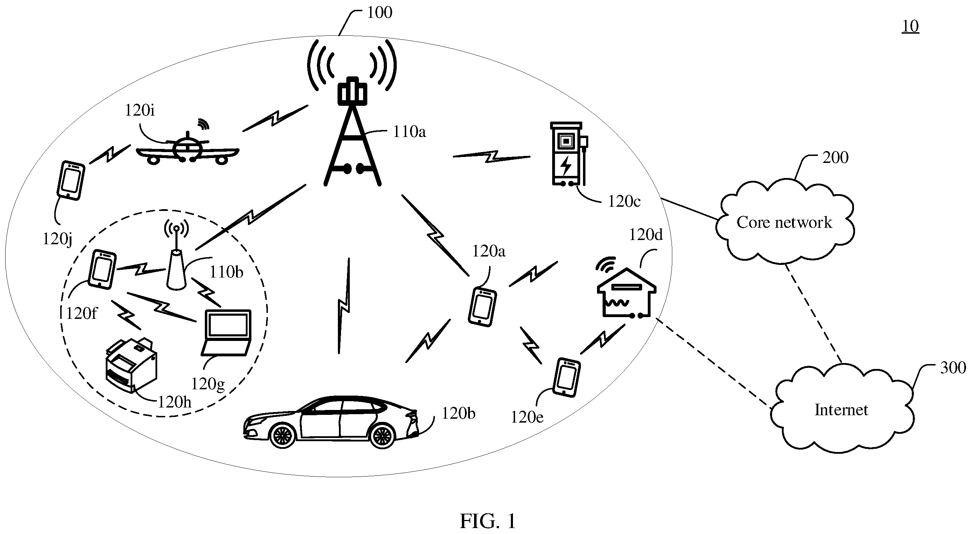

FIG. 1 is a diagram of a possible and non-limiting system. As shown in FIG. 1, a communication system 10 includes a radio access network (radio access network, RAN) 100 and a core network (core network, CN) 200. The RAN 100 includes at least one RAN node (for example, 110a and 110b in FIG. 1, which are collectively referred to as 110) and at least one terminal (for example, 120a to 120j in FIG. 1, which are collectively referred to as 120). The RAN 100 may further include another RAN node, for example, a wireless relay device and/or a wireless backhaul device (not shown in FIG. 1). The terminal 120 is connected to the RAN node 110 in a wireless manner. The access network node (or referred to as a RAN node) 110 is connected to the core network 200 in a wireless or wired manner. A core network device in the core network 200 and the access network node 110 in the RAN 100 may respectively be different physical devices, or may be a same physical device that integrates a logical function of the core network and a logical function of the radio access network.

The RAN 100 may be a cellular system related to the 3rd generation partnership project (3rd generation partnership project, 3GPP), for example, a 4G mobile communication system, a 5G mobile communication system, or a future-oriented evolved system (for example, a 6G mobile communication system). The RAN 100 may alternatively be an open access network (open RAN, O-RAN or ORAN), a cloud radio access network (cloud radio access network, CRAN), or a wireless fidelity (wireless fidelity, Wi-Fi) system. The RAN 100 may alternatively be a communication system that integrates two or more of the foregoing systems.

A first communication apparatus and/or a second communication apparatus provided in this application may be an access network node, for example, the access network node 110 shown in FIG. 1, and sometimes may also be referred to as an access network device, a RAN entity, an access node, or the like, and constitute a part of a communication system, to help a terminal implement radio access. A plurality of access network nodes 110 in the communication system 10 may be nodes of a same type, or may be nodes of different types. In some scenarios, roles of the access network node 110 and the terminal 120 are relative. For example, a network element 120i in FIG. 1 may be a helicopter or an uncrewed aerial vehicle, and may be configured as a mobile base station. For the terminal 120j that accesses the RAN 100 through the network element 120i, the network element 120i is a base station. However, for a base station 110a, the network element 120i is a terminal. Both the access network node 110 and the terminal 120 are sometimes referred to as communication apparatuses. For example, network elements 110a and 110b in FIG. 1 may be understood as communication apparatuses having a base station function, and network elements 120a to 120j may be understood as communication apparatuses having a terminal function.

In a possible scenario, the access network node may be a base station (base station), an evolved NodeB (evolved NodeB, eNodeB), an access point (access point, AP), a transmission reception point (transmission reception point, TRP), a next generation NodeB (next generation NodeB, gNB), a next generation NodeB in a 6th generation (6th generation, 6G) mobile communication system, a base station in a future mobile communication system, an access node in a Wi-Fi system, or the like. The access network node may be a macro base station (for example, 110a in FIG. 1), a micro base station or an indoor station (for example, 110b in FIG. 1), a relay node or a donor node, or a radio controller in a CRAN scenario. Optionally, the access network node may alternatively be a server, a wearable device, a vehicle, a vehicle-mounted device, or the like. For example, an access network device in a vehicle to everything (vehicle to everything, V2X) technology may be a road side unit (road side unit, RSU). All or some of functions of the access network node in this application may alternatively be implemented by using a software function running on hardware, or may be implemented by using an instantiated virtualization function on a platform (for example, a cloud platform). The access network node in this application may alternatively be a logical node, a logical module, or software that can implement all or some of functions of the access network node.

In another possible scenario, a plurality of access network nodes coordinate to assist the terminal in implementing radio access, and different access network nodes separately implement a part of functions of the base station. For example, the access network node may be a central unit (central unit, CU), a distributed unit (distributed unit, DU), a CU-control plane (control plane, CP), a CU-user plane (user plane, UP), or a radio unit (radio unit, RU). The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

The first communication apparatus and/or the second communication apparatus provided in this application may be a terminal, and the terminal may also be referred to as a terminal device, user equipment (user equipment, UE), a mobile station, a mobile terminal, or the like. The terminal may be widely used for communication in various scenarios. The scenarios include, but are not limited to, at least one of the following scenarios: enhanced mobile broadband (enhanced mobile broadband, eMBB), ultra-reliable low-latency communication (ultra-reliable low-latency communication, URLLC), massive machine-type communication (massive machine-type communication, mMTC), D2D, V2X, machine-type communication (machine-type communication, MTC), internet of things (internet of things, IoT), virtual reality, augmented reality, industrial control, autonomous driving, telemedicine, a smart grid, smart furniture, a smart office, smart wearable, smart transportation, a sensing terminal, a terminal with integrated sensing and communication, a smart city, or the like. The terminal may be a mobile phone (for example, 120a, 120j, and 120e in FIG. 1), a tablet computer, a computer with a wireless transceiver function (for example, 120g in FIG. 1), customer-premises equipment (customer-premises equipment, CPE), a smart point of sale (point of sale, POS) machine, a wearable device, a vehicle (for example, 120b in FIG. 1), an uncrewed aerial vehicle, a helicopter, an airplane (for example, 120i in FIG. 1), a ship, a robot, a robotic arm, a sensor, a perceptron, a smart home device (for example, 120h in FIG. 1), or the like.

The following describes related technologies and terms in embodiments of this application.

Dictionary learning is currently an effective method of data compression. Dictionary learning aims to extract the most essential features of an object. If a dictionary containing the most essential features of an object is obtained, the most essential connotation of the object can be captured. Information dimensionality reduction may be performed on an object via a dictionary, which reduces interference from irrelevant information in defining the object.

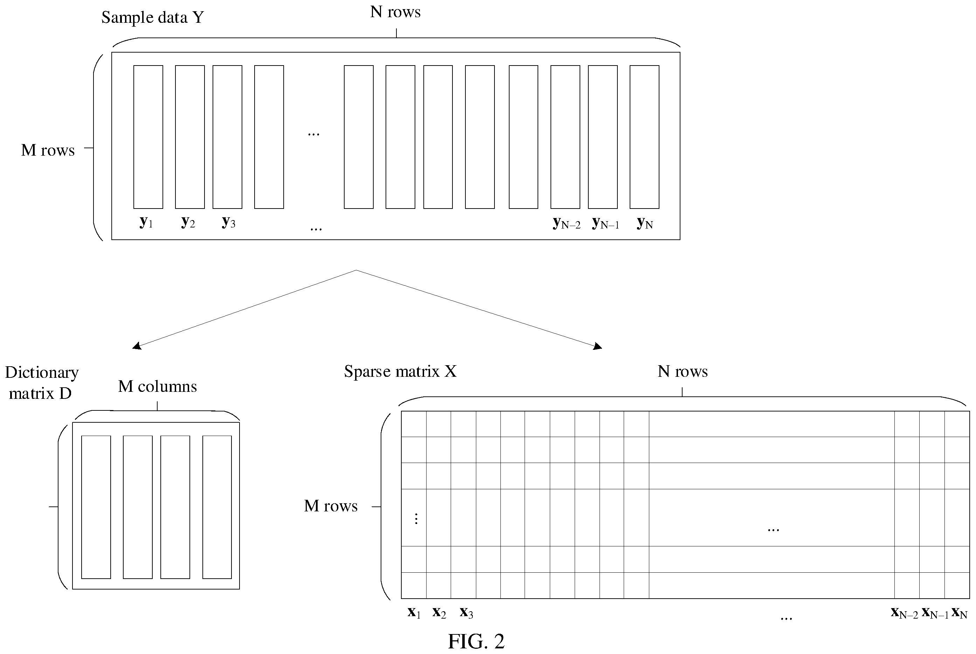

Dictionary learning may be understood as a process of finding an appropriate dictionary for a sample with a common dense representation, and converting the sample into an appropriate sparse representation form, thereby simplifying a learning task and reducing model complexity. As shown in FIG. 2, an original sample set with a common dense representation may be denoted as a matrix Y with M rows and N columns. It may be understood that the original sample set Y includes N samples, and each of the M rows represents an attribute of the samples. The original sample Y may be sparsely represented by using a dictionary matrix D with M rows and P columns. Sparse representation means searching for a sparse matrix X with P rows and N columns and a dictionary matrix D, so that DX restores Y as much as possible, and X is as sparse as possible. In this case, X is a sparse representation of Y. Herein, P may be equal to M, or may not be equal to M. Mathematically, this can be expressed as: A column vector *xᵢ* in the sparse matrix X is a projection vector of a column vector *yᵢ* (that is, a single sample) of the original sample Y onto a dictionary matrix, where 1≤*i*≤N.

The original problem of dictionary learning can be expressed as the following optimization problem: $x = {min}_{\begin{matrix}\left[{x}_{1},{x}_{2},⋯{x}_{N}\right] \\ D\end{matrix}} {\sum }_{i = 1}^{N} {\left‖{D}^{T}{y}_{i}-{x}_{i}\right‖}^{2}$ $s . t . {\left‖{x}_{i}\right‖}_{0} < {T}_{0} , {D}^{T} D = I$

That is, given that X is sufficiently sparse and the dictionary matrix is an orthogonal matrix, the sparse matrix X and the dictionary matrix D that minimize ${\sum }_{i = 1}^{N} {\left‖{D}^{T}{y}_{i}-{x}_{i}\right‖}^{2}$ are solved. When dictionary learning is applied to data compression, a data transmitting side may solve the dictionary matrix D and the sparse matrix X based on the sample data Y, and then send D and X to a receiving side, to compress the sample data Y. A sparser X indicates a smaller amount of data to be transmitted and better compression performance. The receiving side may recover the sample data Y based on D and X. However, solving for the sparse matrix X and the dictionary matrix D at the data transmitting side by applying dictionary learning to the data sample set Y based on the foregoing optimization problem requires a large quantity of iterative computations. Each iterative computation includes at least one singular value decomposition (singular value decomposition, SVD), resulting in high data processing complexity, high power consumption at the data transmitting side, and a high requirement on performance of the data transmitting side.

For the foregoing problem of high complexity of the dictionary learning-based data compression method, this application proposes that data space division may be performed on an original sample set, a corresponding sub-basis matrix for data compression is determined for a data subset belonging to each data space, and the corresponding data subset is compressed based on each sub-basis matrix to obtain compressed data. According to this manner, complexity of data compression can be reduced, compression efficiency can be improved, and power consumption of the data transmitting side can be reduced.

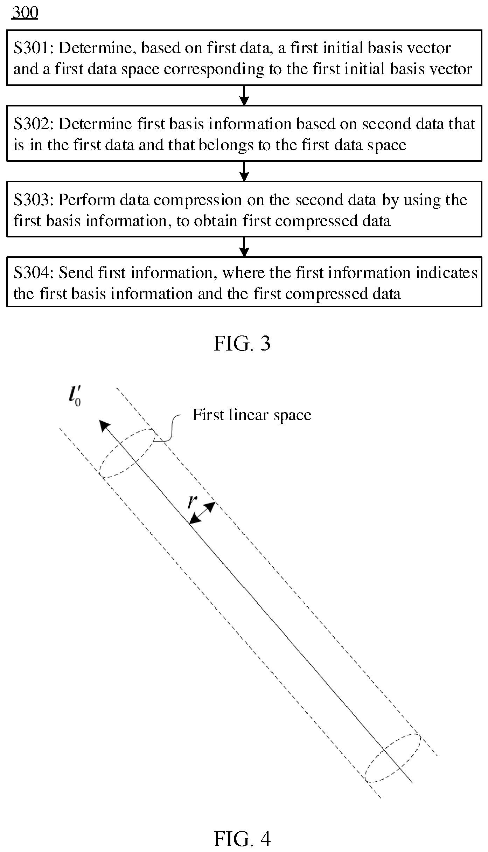

FIG. 3 is a schematic flowchart of a data compression method 300 according to an embodiment of this application. The data compression method may be performed by a first communication apparatus. Before sending data to a second communication apparatus, the first communication apparatus compresses the data by using the method 300, and sends compressed data to the second communication apparatus. The second communication apparatus decompresses the compressed data in a corresponding decompression manner, and then restores the data. It should be understood that the first communication apparatus and/or the second communication apparatus may be communication devices, or the first communication apparatus and/or the second communication apparatus may be components (such as a chip or a chip system) configured in a communication device, or may be logical modules or software that can implement all or some functions of the first communication apparatus. This is not limited in this application.

Before the solution of the method 300 shown in FIG. 3 is described, it should be noted that the first communication apparatus may compress, based on basis information, to-be-compressed data corresponding to the basis information, to obtain compressed data. In this application, the to-be-compressed data, the basis information, and the compressed data may all be represented mathematically in a form of matrix. The to-be-compressed data may be represented in a form of to-be-compressed data matrix. The to-be-compressed data matrix may include a plurality of data vectors, and the plurality of data vectors may be considered as a plurality of data samples. The basis information indicates a basis matrix, and the basis matrix may include a plurality of basis vectors. In other words, the basis information may indicate the plurality of basis vectors included in the basis matrix. The compressed data may be represented as a compressed data matrix, the compressed data matrix includes a plurality of compressed data vectors, and one compressed data vector is obtained by compressing one to-be-compressed data vector in the to-be-compressed data matrix by using the basis matrix.

S301: The first communication apparatus determines, based on first data, a first initial basis vector and a first data space corresponding to the first initial basis vector.

The first data is to-be-transmitted data. The first communication apparatus may first determine first initial basis information based on the first data, where the first initial basis information indicates a first initial basis matrix, and the first initial basis matrix includes the first initial basis vector. A manner in which the first communication apparatus determines the first initial basis information may include but is not limited to an implementation 1 to an implementation 3 below.

In the implementation 1, the first communication apparatus may determine, based on the first data, one piece of candidate basis information in a plurality of pieces of candidate basis information as the first initial basis information.

For example, a candidate basis information repository may be preconfigured in the first communication apparatus, and the first communication apparatus may determine, based on the first data, the first initial basis information in the candidate basis information repository. Preferably, the first initial basis information may be candidate basis information that is in the candidate basis information repository and that makes a representation coefficient, based on the first initial basis information, of the first data the sparsest. However, this application is not limited thereto.

A representation coefficient, based on one piece of basis information, of data is a projection coefficient obtained by projecting a data matrix corresponding to the data onto a basis matrix corresponding to the basis information. In other words, the representation coefficient, based on the one piece of basis information, of the data may be understood as compressed data obtained by compressing the data based on the basis information.

In the implementation 2, the first communication apparatus may obtain, based on the first data, the first initial basis information by using a principal component analysis method.

In the implementation 3, the first communication apparatus may perform, based on the first data, a small quantity of iterations in a dictionary learning manner, to obtain the first initial basis information.

Because it is highly complex for the first communication apparatus to obtain, through a plurality of iterations in the dictionary learning manner until a stopping condition is met, the basis information for compressing the first data, this implementation proposes performing the small quantity of iterations in the dictionary learning manner based on the first data to obtain one piece of initial basis information, that is, the first initial basis information, and then performing processing based on the solution provided in this application. This can reduce computational complexity of obtaining the basis information.

The first initial basis matrix indicated by the first initial basis information includes the first initial basis vector, and a spatial line *l*₀ in which the first initial basis vector is located may be represented as: ${l}_{0} = {β}_{0} t$

Herein, *β*₀ is a direction vector of the spatial line *l*₀ , and the direction vector *β*₀ is a unit vector, that is, a modulus value of ***β***₀ is 1. Sample data in the first data is concentrated on a line ${l}_{0}^{′}$ parallel to the line ***l***₀ in which the first initial basis vector is located, or around the line, and the line ${l}_{0}^{′}$ is a line closest (or relatively close) to the sample data in the first data. The line ${l}_{0}^{′}$ may be represented as: ${l}_{0}^{′} = {β}_{0} t + {α}_{0}$

Herein, ***α***₀ represents a spatial offset of the spatial line ${l}_{0}^{′}$ from an origin.

The first communication apparatus may determine the first data space based on the line ${l}_{0}^{′}$ and a first distance *r*. The first communication apparatus may determine that a coverage space of points whose distances from points on the spatial line ${l}_{0}^{′}$ are the first distance r is the first data space, as shown in FIG. 4. The data space in this application may also be referred to as a linear space, that is, a space determined based on a spatial line. This is not limited in this application. The spatial line ${l}_{0}^{′}$ is a principal axis line of the first data space. In this application, the first data space is referred to as a data space corresponding to the first initial basis vector. In other words, the first initial basis vector corresponds to the first data space.

The first distance for determining the first data space may be predefined in a protocol. Alternatively, the first distance may be determined by the first communication apparatus and the second communication apparatus through signaling interaction. The first communication apparatus and the second communication apparatus reach a consensus on the first distance.

S302: The first communication apparatus determines first basis information based on second data that is in the first data and that belongs to the first data space.

After determining the first data space in S301, the first communication apparatus may determine the second data that is in the first data and that belongs to the first data space, where a data sample included in the second data is located in the first data space. The first communication apparatus may determine the first basis information based on the second data, where the first basis information is used to compress the second data.

Specifically, the first communication apparatus may adjust the first initial basis information based on the second data, and determine the first basis information. A representation coefficient of the second data with respect to the first basis information, is sparser than a representation coefficient of the second data with respect to the first initial basis information.

In an implementation, the first communication apparatus may adjust a direction of the first initial basis matrix indicated by the first initial basis matrix information, so that a representation coefficient, based on a basis matrix obtained after direction adjustment, of the second data is as sparse as possible. The basis matrix obtained after direction adjustment is a first basis matrix, and may be denoted as ***D***₀. The first basis matrix may be indicated by the first basis information.

For example, the first communication apparatus may first adjust a direction of the principal axis line ${l}_{0}^{′}$ of the first data space, so that a distance between sample data in the second data and a line obtained after direction adjustment is as small as possible. For example, a sum of distances from the sample data in the second data to the line obtained after the direction adjustment is less than a sum of distances from the sample data in the second data to the line before the adjustment. The first communication apparatus determines an angle by which the principal axis line of the first data space is adjusted, and the first communication apparatus adjusts, based on the angle, the direction of the first initial basis matrix indicated by the first initial basis information, to obtain the first basis matrix. The first basis matrix is a basis matrix obtained after a direction of each basis vector in the first initial basis matrix is adjusted based on the angle.

S303: The first communication apparatus performs data compression on the second data by using the first basis information, to obtain first compressed data.

Specifically, the first communication apparatus may perform data compression on the second data by using the first basis matrix indicated by the first basis information, to obtain the first compressed data. That is, the first communication apparatus may project the data sample in the second data onto the first basis matrix, to obtain a sparse matrix, where the sparse matrix is the first compressed data.

In an implementation, after the first communication apparatus processes the second data based on the first spatial offset to obtain processed data, the first communication apparatus compresses the processed data based on the first basis information to obtain the first compressed data. The first spatial offset is a spatial offset *α*₀ of the principal axis line of the first data space. The first spatial offset may be referred to as a spatial offset corresponding to the first data space.

An offset of the principal axis line ${l}_{0}^{′}$ of the first data space relative to the origin is ***α***₀, and the data sample in the second data is located near the principal axis line ${l}_{0}^{′}$ in the first data space. Therefore, the data sample in the second data may be compressed after the first spatial offset ***α***₀ is removed, which can further reduce an amount of compressed data. Specifically, a data matrix corresponding to the second data may be denoted as ***Y***₀ , and the first communication apparatus may obtain ***Y***₀ *- **α***₀ by moving the second data by the first spatial offset ***α***₀ . Then, the first communication apparatus compresses ***Y***₀ *- **α***₀ based on the first basis matrix ***D***₀ indicated by the first basis information, to obtain the first compressed data. That is, the first compressed data is a sparse matrix ***X***₀ obtained by projecting ***Y***₀ *- α*₀ onto the first basis matrix. The first communication apparatus may notify the second communication apparatus of the first spatial offset, so that the second communication apparatus decompresses to restore the data.

S304: The first communication apparatus sends first information, where the first information indicates the first basis information and the first compressed data.

After performing data compression on the second data based on the first basis information to obtain the first compressed data, the first communication apparatus notifies the second apparatus of the first basis information and the first compressed data by using the first information, so that the second communication apparatus performs data decompression based on the first basis information and the first compressed data to recover the second data.

For remaining data other than the second data in the first data, the first communication apparatus may continue to determine at least one data space, and then determine basis information corresponding to each data space, where the basis information is used to perform data compression on data in a corresponding data space. It should be noted that the first communication apparatus may perform an operation of determining the basis information corresponding to the remaining data before S303, or may perform the operation of determining the basis information corresponding to the remaining data after S303, or may perform the operation simultaneously with S303. An execution sequence thereof is not limited in this application.

A manner in which the first communication apparatus determines basis information corresponding to data other than the second data in the first data may include but is not limited to an implementation 1 or an implementation 2 below. The following separately describes the implementations.

Implementation 1: The first communication apparatus determines, based on third data, a second initial basis vector and a second data space corresponding to the second initial basis vector, where the third data is data other than the second data in the first data. The first communication apparatus determines second basis information based on fourth data that is in the third data and that belongs to the second data space.

In an implementation 1-1, the first communication apparatus processes the third data in a manner identical to that used for the first data. To be specific, the first communication apparatus may determine, based on the third data, second initial basis information by using, but is not limited to, one of the implementation 1 to the implementation 3 described above, and a second initial basis matrix indicated by the second initial basis information includes the second initial basis vector. Then, the first communication apparatus determines, based on the second initial basis vector and the first distance, the second data space corresponding to the second initial basis information. If the first communication apparatus determines that the data that is in the third data and that belongs to the second data space is the fourth data, the first communication apparatus adjusts the second initial basis information based on the fourth data, to obtain the second basis information, where the second basis information is used to compress the fourth data. For a specific implementation procedure, refer to the foregoing descriptions in S301 and S303. Details are not described herein again. The first communication apparatus further sends second information to the second communication apparatus, where the second information indicates the second basis information and second compressed data, and the second compressed data is obtained by the first communication apparatus by compressing the fourth data based on the second basis information. Optionally, if the first communication apparatus processes the fourth data based on a spatial offset of a principal axis line of a second linear space and then compresses the fourth data, the second information further indicates the spatial offset. It should be noted that the first information and the second information may be separately sent to the second communication apparatus. Herein, "separately sent" may mean that the first information and the second information are separately quantized and coded and then sent, or mean that the first information and the second information are carried in different messages or time units. Alternatively, the first information and the second information may be sent together to the second communication apparatus. Herein, "sent together" may mean that the first information and the second information may be quantized and coded together as a whole and then sent, or mean that the first information and the second information are carried in a same message or time unit.

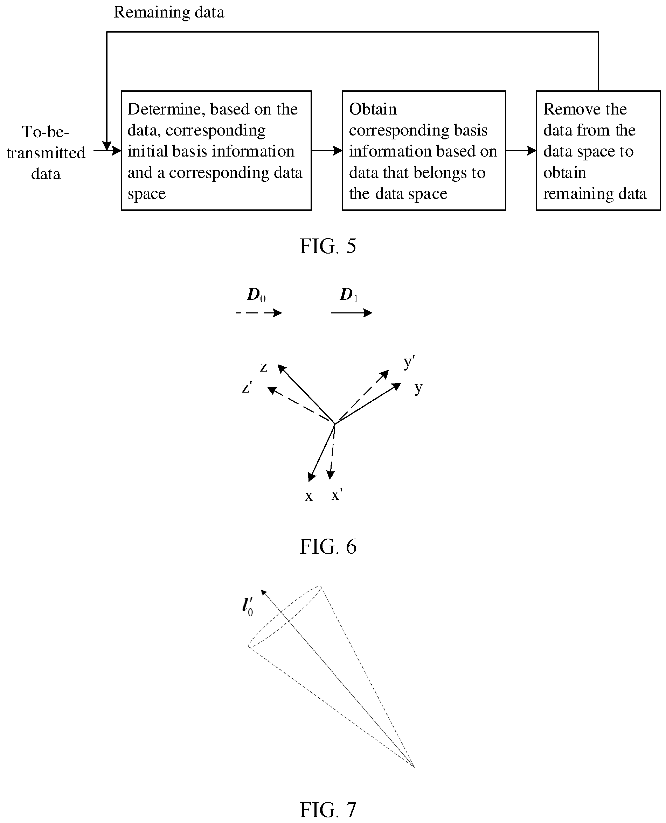

Data other than the fourth data in the third data may continue to be processed by using the implementation 1-1. A specific processing procedure of to-be-transmitted data in the implementation 1-1 may be shown in FIG. 5. First, corresponding initial basis information is determined based on the to-be-transmitted data by using one of the foregoing implementation 1 to implementation 3, a corresponding data space is determined based on one initial basis vector indicated by the initial basis information, and then corresponding basis information is determined based on data belonging to the data space and the initial basis information. Then, the above steps are repeated for remaining data obtained after removing the data belonging to the data space. In each iteration, a data space to which a part of the data belongs and basis information used to compress the part of data are obtained. When the remaining data is less than a data threshold, the first communication apparatus may stop the iterative operation to obtain final remaining data. The final remaining data may not be compressed, but is directly sent to the second communication apparatus after being directly subjected to subsequent processing (such as quantization and entropy coding). For example, the data threshold may be a predefined percentage, for example, 0.1%. When the remaining data is less than 0.1% of the first data, the first communication apparatus stops the iterative operation. For data for which corresponding basis information has been determined, the first communication apparatus performs data compression on the data in the corresponding data space by using the basis information, to obtain compressed data (corresponding to a sparse matrix ***X**ⱼ* ). For example, the first communication apparatus finally determines M pieces of basis information corresponding to data in M data spaces, where 0≤*j*≤M-1. The first communication apparatus may indicate, to the second communication apparatus via information, the M pieces of basis information (corresponding to M basis matrices ***D**ⱼ* ) and M pieces of compressed data (corresponding to M sparse matrices ***X**ⱼ*) obtained by performing compression based on the M pieces of basis information. The first communication apparatus may separately indicate each piece of basis information and corresponding compressed data via M pieces of information. The M pieces of information may be separately sent to the second communication apparatus, or may be sent to the second communication apparatus together. For example, two of the M pieces of information are respectively first information and second information. Correspondingly, after receiving the first information, the second communication apparatus may decompress the corresponding compressed data based on each of the M pieces of basis information to obtain decompressed data. Optionally, if the first communication apparatus processes data in a corresponding data space by using a spatial offset ***α**ⱼ* of a principal axis line of each data space and then compresses the data, the first communication apparatus may further notify the second communication apparatus of M spatial offsets ***α**ⱼ* via information. Correspondingly, after obtaining the M spatial offsets, the second communication apparatus may decompress corresponding compressed data ***X**ⱼ* based on each piece of basis information ***D**ⱼ* to obtain a data matrix ***Y**ⱼ - **α**ⱼ,* and then perform shift processing based on the spatial offset ***α**ⱼ* to obtain data ***Y**ⱼ* through recovery.

In an implementation, information (such as the first information and the second information) that is sent by the first communication apparatus to the second communication apparatus and that indicates basis information may be specifically that the information includes the basis information. For example, the first information includes the first basis information, and the second information includes the second basis information.

In another implementation, the first information sent by the first communication apparatus to the second communication apparatus may include the first basis information, and the first communication apparatus may notify the second communication apparatus of corresponding basis information by indicating differential information between the first basis information and other basis information. Information overheads can be reduced, and resource utilization can be improved. For example, the second information may include differential information between the first basis information and the second basis information. The differential information may include angle information, and the angle information indicates an angular difference between the first basis information and the second basis information.

In an example, differential information corresponding to basis information *j* in the M pieces of basis information may be offset angle information between a basis matrix ***D**ⱼ* (*j* ≠ 0) indicated by the basis information *j* and the first basis matrix ***D***₀ corresponding to the first basis information. For example, the offset angle information indicates three offset angles ${θ}_{x}^{\left(j\right)} , {θ}_{y}^{\left(j\right)}$*,* and ${θ}_{z}^{\left(j\right)}$*.* One rotation matrix *R*^{(*j*)} may be determined by the three offset angles. For example, *R*^{(*j*)} may be represented as follows: ${R}^{\left(j\right)} = {R}_{z}^{\left(j\right)} \left({θ}_{z}^{\left(j\right)}\right) {R}_{y}^{\left(j\right)} \left({θ}_{y}^{\left(j\right)}\right) {R}_{x}^{\left(j\right)} \left({θ}_{x}^{\left(j\right)}\right) = \left[\begin{matrix}{cosθ}_{z}^{\left(j\right)} & - {sinθ}_{z}^{\left(j\right)} & 0 \\ {sinθ}_{z}^{\left(j\right)} & {cosθ}_{z}^{\left(j\right)} & 0 \\ 0 & 0 & 1\end{matrix}\right] \left[\begin{matrix}{cosθ}_{y}^{\left(j\right)} & 0 & {sinθ}_{y}^{\left(j\right)} \\ 0 & 1 & 0 \\ - {sinθ}_{y}^{\left(j\right)} & 0 & {θ}_{y}^{\left(j\right)}\end{matrix}\right] \left[\begin{matrix}1 & 0 & 0 \\ 0 & {cosθ}_{x}^{\left(j\right)} & - {sinθ}_{x}^{\left(j\right)} \\ 0 & {sinθ}_{x}^{\left(j\right)} & {cosθ}_{x}^{\left(j\right)}\end{matrix}\right]$

Herein, ${R}_{x}^{\left(j\right)} \left({θ}_{x}^{\left(j\right)}\right)$ is a rotation matrix corresponding to an angle ${θ}_{x}^{\left(j\right)}$ of rotation of the basis matrix ***D**ⱼ* relative to the first basis matrix ***D***₀ based on an x-axis, ${R}_{y}^{\left(j\right)} \left({θ}_{y}^{\left(j\right)}\right)$ is a rotation matrix corresponding to an angle ${θ}_{y}^{\left(j\right)}$ of rotation of the basis matrix ***D**ⱼ* relative to the first basis matrix ***D***₀ based on a *y*-axis, and ${R}_{z}^{\left(j\right)} \left({θ}_{z}^{\left(j\right)}\right)$ is a rotation matrix corresponding to an angle ${θ}_{z}^{\left(j\right)}$ of rotation of the basis matrix ***D**ⱼ* relative to the first basis matrix ***D***₀ based on a z-axis. Basis matrices ***D**ⱼ* and ***D***₀ in a given space may be shown in FIG. 6. Two basis matrices may uniquely determine a group of rotation angles ${θ}_{x}^{\left(j\right)} , {θ}_{y}^{\left(j\right)}$*,* and ${θ}_{z}^{\left(j\right)}$. A specific determining manner is as follows: ${θ}_{x} = {tan}^{- 1} \frac{\left(z′⋅y\right)}{\left(z′⋅z\right) ′} ;$ ${θ}_{y} = - {sin}^{- 1} \left(z′⋅x\right) ;$ and ${θ}_{z} = {tan}^{- 1} \frac{\left(y′⋅x\right)}{\left(x′⋅x\right)} .$

Herein, (·) represents an inner product of two vectors. The second communication apparatus obtains, via the first information, the rotation angles ${θ}_{x}^{\left(j\right)} , {θ}_{y}^{\left(j\right)}$*,* and ${θ}_{z}^{\left(j\right)}$ of the basis matrix ***D**ⱼ* relative to the first basis matrix, determines a rotation matrix, obtain, based on the rotation matrix *R*^{(*j*)} and the first basis matrix ***D***₀, the basis matrix, that is ***D**ⱼ = R*^{(*j*)}***D***₀ , and performs data decompression.

In another example, unit rotation angles Δ*θₓ* , Δ*θ_{y}*, and Δ*θ_{z}* corresponding to the three axes may be predefined. Differential information may indicate three rotation components ${n}_{x}^{j} , {n}_{y}^{j}$*,* and ${n}_{z}^{j}$ corresponding to basis information. One rotation component is a quantity of unit rotation angles that correspond to one axis of the first basis matrix ***D***₀ and that are included in an angle of rotation of the basis matrix ***D**ⱼ* corresponding to the basis information *j* relative to the axis. For example, ${n}_{x}^{j} = \left⌊\frac{{θ}_{x}^{\left(j\right)}}{Δ {θ}_{x}}\right⌋ , {n}_{y}^{j} = \left⌊\frac{{θ}_{y}^{\left(j\right)}}{Δ {θ}_{y}}\right⌋ , and {n}_{z}^{j} = \left⌊\frac{{θ}_{z}^{\left(j\right)}}{Δ {θ}_{z}}\right⌋ .$

The second communication apparatus receives, from the first communication apparatus, three rotation components corresponding to each basis matrix, thereby obtaining three rotation angles of the basis matrix relative to the first basis matrix. After determining a rotation matrix based on the three rotation angles, the second communication apparatus obtains the corresponding basis matrix based on the rotation matrix and the first basis matrix, thereby performing data decompression. The foregoing describes the implementation 1-1, and the following describes an implementation 1-2.

In the implementation 1-2, the first communication apparatus may adjust reference basis information based on a target space determined based on the third data, to obtain second initial basis information. The first communication apparatus may further determine the second data space corresponding to the second initial basis vector, thereby determining the fourth data that is in the third data and that belongs to the second data space. The first communication apparatus adjusts the second initial basis information based on the fourth data, to obtain the second basis information, where the second basis information is used to compress the fourth data.

For example, the reference basis information may be the first basis information.

According to statistical analysis, the remaining data (that is, the third data) other than the second data in the first data belongs to a conical space defined by taking a principal axis line ${l}_{0}^{′}$ of the first data space as an axis. For example, the conical space is shown in FIG. 7. The conical space is the target space determined based on the third data. If a line obtained by rotating the principal axis line ${l}_{0}^{′}$ by any angle *φ* still belongs to the conical space, it can at least be ensured that some data in the conical space exhibit specific sparsity when projected onto a second initial basis matrix obtained by rotating the first basis matrix ***D***₀ based on the angle *φ* . Therefore, the first communication apparatus may first determine, based on the conical space to which the third data belongs, a rotatable angle of the first basis matrix ***D***₀. That is, a line ${l}_{1}^{′}$ obtained by rotating the principal axis line ${l}_{0}^{′}$ by the rotatable angle is still located in the data space. The first communication apparatus then rotates the first basis matrix ***D***₀ by the rotatable angle to obtain the second initial basis matrix. The line ${l}_{1}^{′}$ is parallel to a line in which the second initial basis vector indicated by the second initial basis information is located. The first communication apparatus may determine, based on the line ${l}_{1}^{′}$ and the first distance, the second data space corresponding to the second initial basis vector. Then, the first communication apparatus adjusts the second initial basis information based on the fourth data that is in the third data and that belongs to the second data space, to obtain the second basis information, where the second basis information is used to compress the fourth data. For a specific manner of adjusting corresponding initial basis information based on data in a data space to obtain corresponding basis information, refer to the descriptions in S302. Details are not described herein again. The first communication apparatus further sends second information to the second communication apparatus, where the second information indicates the second basis information and second compressed data, and the second compressed data is obtained by the first communication apparatus by compressing the fourth data based on the second basis information. Optionally, if the first communication apparatus processes the fourth data based on a spatial offset of a principal axis line of a second linear space and then compresses the fourth data, the second information further indicates the spatial offset.

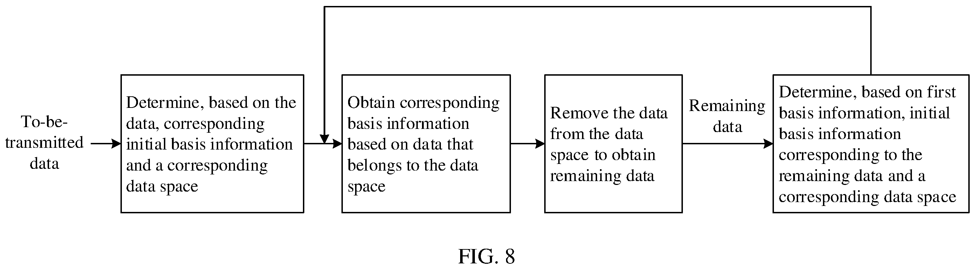

For remaining data other than the fourth data in the third data, the implementation 1-2 may continue to be used to determine a data space to which the remaining data belongs, obtain corresponding initial basis information by adjusting the first basis information, and after the corresponding data space is determined, adjust the initial basis information based on the data belonging to the data space to obtain corresponding basis information. Repeat the implementation 1-2 until an amount of remaining data is less than a data threshold. A specific processing procedure of to-be-transmitted data in the implementation 1-2 may be shown in FIG. 8.

For data for which corresponding basis information has been determined, the first communication apparatus performs data compression on data in a corresponding data space by using the basis information, to obtain compressed data (corresponding to a sparse matrix ***X**ⱼ*). For example, the first communication apparatus finally determines M pieces of basis information corresponding to data in M data spaces, where 0≤*j*≤M-1. The first communication apparatus may indicate, to the second communication apparatus via information, the M pieces of basis information (corresponding to M basis matrices ***D**ⱼ* ) and M pieces of compressed data (corresponding to M sparse matrices ***X**ⱼ* ) obtained by performing compression based on the M pieces of basis information. The first communication apparatus may separately indicate the M pieces of basis information and the corresponding compressed data via M pieces of information. For example, two of the M pieces of information are respectively the first information and the second information. Alternatively, the first communication apparatus may indicate the M pieces of basis information and the correspondingly compressed data via one piece of information. For example, the one piece of information may include the first information and the second information. Correspondingly, after receiving the first information, the second communication apparatus may decompress the corresponding compressed data based on each of the M pieces of basis information to obtain decompressed data.

Optionally, if the first communication apparatus processes data in a corresponding data space by using a spatial offset ***α**ⱼ* of a principal axis line of each data space and then compresses the data, the first communication apparatus may further notify the second communication apparatus of M spatial offsets ***α**ⱼ* via information. Correspondingly, after obtaining the M spatial offsets, the second communication apparatus may decompress corresponding compressed data based on each piece of basis information to obtain a data matrix set ***Y**ⱼ - **α**ⱼ,* and then perform shift processing based on the spatial offset ***α**ⱼ* to obtain data ***Y**ⱼ* through recovery.

Specifically, a manner in which the first communication apparatus indicates the M pieces of basis information may be directly transmitting the M pieces of basis information. Alternatively, the first information sent by the first communication apparatus includes the first basis information ***D***₀, and information indicating other M-1 pieces of basis information includes differential information between the basis information and the first basis information ***D***₀. For example, the second information may include differential information between the second basis information and the first basis information. For a specific implementation, refer to the descriptions in the foregoing implementation 1-1. Details are not described herein again.

It should be understood that the foregoing uses an example in which the reference basis information is the first basis information for description. The reference basis information may alternatively be basis information determined by the first communication apparatus in a predefined candidate basis information repository based on the third data. For example, the reference basis information is basis information that is in the candidate basis information repository and that makes a projection of the third data sparse. However, this application is not limited thereto. The reference basis information may alternatively be other basis information. Optionally, the first communication apparatus may notify the second communication apparatus of the reference basis information, so that the second communication apparatus may determine the reference basis information selected by the first communication apparatus.

The foregoing describes two specific implementations of the implementation 1: the implementation 1-1 and the implementation 1-2. The following describes another implementation, that is, an implementation 2, of determining the basis information corresponding to the remaining data.

Implementation 2: The first communication apparatus determines, based on third data and the first basis information, maximum differential information between basis information. The first communication apparatus determines, based on the maximum differential information and division precision, a plurality of data spaces and basis information corresponding to the plurality of data spaces. Data that is in the third data and that belongs to one data space is compressed by using basis information corresponding to the data space.

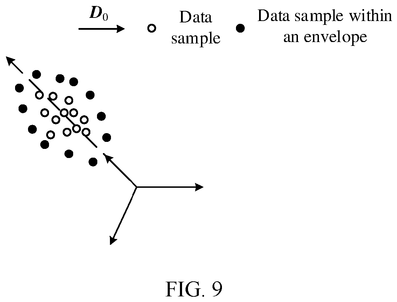

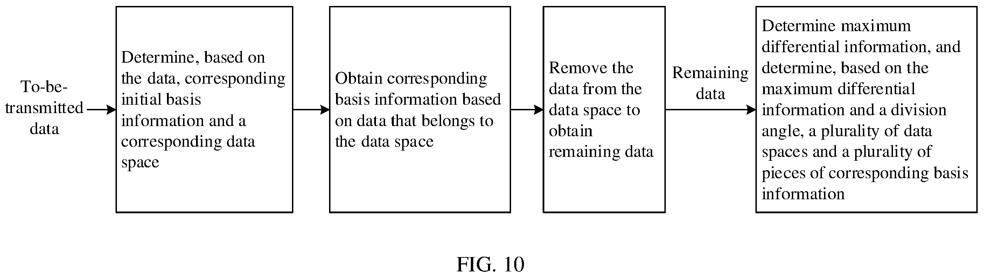

The first communication apparatus may perform envelope detection on the third data, to obtain a data sample that is in the third data and that is within an envelope, as shown in FIG. 9. The first communication apparatus may first determine, based on the data sample within the envelope, a maximum rotation angle corresponding to the first basis information, that is, maximum rotation angles ${θ}_{x}^{max} , {θ}_{y}^{max}$, and ${θ}_{z}^{max}$ of ***D***₀. Then, the first communication apparatus divides, based on division precision corresponding to each axis, the maximum rotation angle of the corresponding axis. The x-axis is used as an example. If division precision of the x-axis is *rₓ* = 16, an interval $\left[0, {θ}_{x}^{max}\right]$ is divided into 16 equal parts. Similarly, an interval $\left[0, {θ}_{y}^{max}\right]$ is divided based on division precision *r_{y}* of the *y*-axis, and an interval $\left[0, {θ}_{z}^{max}\right]$ is divided based on division precision *r_{z}* of the z-axis, to obtain *rₓr_{y}r_{z}* angle combinations ( ${θ}_{x}^{j} , {θ}_{y}^{j} , {θ}_{z}^{j}$), where 1≤*j*≤*rₓr_{y}r_{z}.* The first communication apparatus may determine *rₓr_{y}r_{z}* data spaces and *rₓr_{y}r_{z}* pieces of corresponding basis information based on the *rₓr_{y}r_{z}* angle combinations. For example, after angle rotation is performed on the first basis matrix ***D***₀ based on one angle combination ( ${θ}_{x}^{j} , {θ}_{y}^{j} , {θ}_{z}^{j}$), a basis matrix ***D**ⱼ* (the basis matrix may be indicated by basis information i) corresponding to the angle combination may be obtained, and after the first data space is rotated based on the angle combination ( ${θ}_{x}^{j} , {θ}_{y}^{j} , {θ}_{z}^{j}$), a data space corresponding to the basis matrix ***D**ⱼ* may be obtained. Data that is in the third data and that belongs to one of the *rₓr_{y}r_{z}* data spaces is compressed by using basis information corresponding to the data space. A processing procedure of the implementation 2 may be shown in FIG. 10.

The first information sent by the first communication apparatus to the second communication apparatus may indicate the first basis information and the first compressed data. The first communication apparatus may further send third information to the second communication apparatus. The third information includes the maximum differential information, and the maximum differential information indicates the maximum rotation angles ${θ}_{x}^{max} , {θ}_{y}^{max}$, and ${θ}_{z}^{max}$ determined by the first communication apparatus, so that after receiving the maximum differential information, the second communication apparatus may determine the *rₓr_{y}r_{z}* angle combinations ( ${θ}_{x}^{j} , {θ}_{y}^{j} , {θ}_{z}^{j}$) based on the maximum rotation angles and the division precision. The first information and the third information may be sent together or separately. This is not limited in this application. The division precision may be predefined, or the third information may further indicate the division precision. The second communication apparatus may determine, based on each angle combination ( ${θ}_{x}^{j} , {θ}_{y}^{j} , {θ}_{z}^{j}$), a rotation matrix *R*^{(*j*)} corresponding to each angle combination. Then based on the rotation matrix *R*^{(*j*)} and the first basis matrix *D*₀, the second communication apparatus obtains a basis matrix ***D**ⱼ - R*^{(*j*)}***D***₀ corresponding to the data space, and then performs data decompression based on the basis matrix ***D**ⱼ* .

Optionally, if the first communication apparatus processes data in a corresponding data space by using a spatial offset ***α**ⱼ* of a principal axis line of each data space and then compresses the data, the third information further indicates *rₓr_{y}r_{z}* spatial offsets {***α**ⱼ*} of principal axis lines of the *rₓr_{y}r_{z}* data spaces. The second communication apparatus recovers the data by performing corresponding processing based on the first information.

However, the *rₓr_{y}r_{z}* data spaces may include a data space that includes data and a data space that does not include data. For example, the *rₓr_{y}r_{z}* data spaces include M data spaces, where M is a positive integer. The M data spaces each include data in the third data. The third information further includes compressed data obtained by separately compressing data in corresponding data spaces based on M pieces of basis information corresponding to the M data spaces.

For a data space that does not include data, the third information does not include compressed data corresponding to the data space. Therefore, the first information further indicates a data space that includes data and/or a data space that does not include data in the *rₓr_{y}r_{z}* data spaces. The second communication apparatus may determine, based on an indication of the first information, a data space corresponding to compressed data included in the first information, and then decompress the compressed data by using basis information corresponding to the corresponding data space, to obtain recovered data.

In an example, the first information includes a bit sequence (the bit sequence may be referred to as a bitmap (bitmap)), the bit sequence includes *rₓr_{y}r_{z}* bits, the *rₓr_{y}r_{z}* bits are in a one-to-one correspondence with the *rₓr_{y}r_{z}* data spaces, and one bit indicates that a corresponding data space includes or does not include data. For example, if the bit is 1, it indicates that the data space corresponding to the bit includes data; or if the bit is 0, it indicates that the data space corresponding to the bit does not include data. The second communication apparatus may determine, based on an indication of each bit in the bit sequence, a data space that includes data and a data space that does not include data.

The interval $\left[0, {θ}_{x}^{max}\right]$ on the x-axis is divided into *rₓ* angles, and identifiers *Iₓ* of the *rₓ* angles may be sequentially denoted as 0 to *rₓ* - 1. Similarly, identifiers *I_{y}* of *r_{y}* angles obtained by dividing the interval [ $0 , {θ}_{y}^{max}$] on the y-axis may be denoted as 0 to *r_{y}* -1, and identifiers *I_{z}* of *r_{z}* angles obtained by dividing the interval $\left[0, {θ}_{z}^{max}\right]$ on the z-axis may be denoted as 0 to *r_{z}* -1.

The *rₓr_{y}r_{z}* bits in the first information sequentially correspond to data spaces obtained based on the *rₓr_{y}r_{z}* angle combinations. For example, identifiers of angle combinations sequentially correspond to a first bit to an *r_{z}* ^{th} bit in the *rₓr_{y}r_{z}* bits are (0,0,0), (0,0,1), (0,0,2),..., and (0,0,*r_{z}* -1), identifiers of angle combinations sequentially correspond to an *r_{z}* + 1^{th} bit to a 2*r_{z}* ^{th} bit are (0,1,0), (0,1,1), (0,1,2), ..., and (0,1,*r_{z}*-1), and so on, and identifiers of angle combinations sequentially correspond to the last *r_{z}* bits are (*rₓ* - 1,*r_{y}* - 1,0) , (*rₓ* - 1,*r_{y}* -1,1) , (*rₓ -*1*,r_{y}* -1,2) , ..., and (*rₓ* -1,*r_{y} -* 1,*r_{z}* -1). That is, the *rₓr_{y}r_{z}* bits correspond to the *rₓr_{y}r_{z}* data spaces obtained based on the *rₓr_{y}r_{z}* angle combinations in the following order: first by sequentially increasing the identifier on the z-axis, then by sequentially increasing the identifier on the *y*-axis, and finally by sequentially increasing the identifier on the x-axis. In this manner, identifiers *Iₓ* , *I_{y} ,* and *I_{z}* of an angle combination of a data space corresponding to a K^{th} bit in the *rₓr_{y}r_{z}* bits are respectively: ${I}_{x} = \left⌊\frac{K + 1}{{r}_{y} {r}_{z}}\right⌋ , {I}_{y} = \left⌊\frac{K + 1 - {I}_{x} \left({r}_{y}{r}_{z}\right) + 1}{{r}_{z}}\right⌋ , and {I}_{z} = \left(K+1-{I}_{x}\left({r}_{y}{r}_{z}\right)+1\right) + 1 - {I}_{x} {r}_{z} - 1$

In another example, each of the *rₓr_{y}r_{z}* data spaces corresponds to one identifier. For example, it may be predefined that the identifiers increase sequentially in the following order: first by sequentially increasing the angle on the x-axis, then by sequentially increasing the angle on the y-axis, and finally by sequentially increasing the angle on the z-axis. In this case, the first information may include an identifier of a data space that is in the *rₓr_{y}r_{z}* data spaces and that does not include data, or include an identifier of a data space that is in the *rₓr_{y}r_{z}* data spaces and that includes data. The second communication apparatus may determine, based on the first information, a data space that includes data or a data space that does not include data in the *rₓr_{y}r_{z}* data spaces.

According to the foregoing solution, the first communication apparatus may perform data space division on the to-be-transmitted data, and determine, based on data in each data space, corresponding basis information for data compression. Compared with inferring basis information based on a dictionary learning manner, this can avoid performing a large quantity of times of SVD decomposition, and reduce execution of a high-complexity algorithm. The basis information for data compression can be determined through low-complexity algorithms such as matrix rotation processing and distance calculation from a data point to a spatial straight. Data compression efficiency can be improved, and power consumption of the apparatus can be reduced.

It may be understood that to implement functions in the foregoing embodiments, the base station and the terminal include corresponding hardware structures and/or software modules for performing the functions. A person skilled in the art should be easily aware that, in this application, the units and method steps in the examples described with reference to embodiments disclosed in this application can be implemented by hardware or a combination of hardware and computer software. Whether a function is performed by hardware or hardware driven by computer software depends on particular application scenarios and design constraints of the technical solutions.

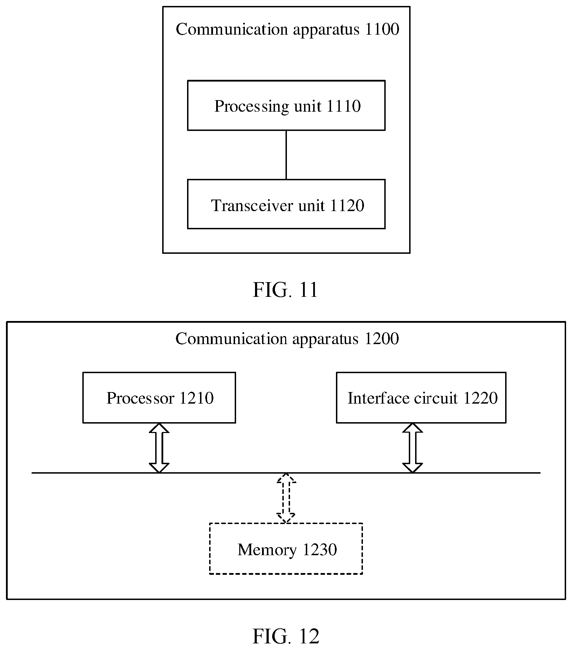

FIG. 11 and FIG. 12 are diagrams of structures of possible communication apparatuses according to embodiments of this application. These communication apparatuses may be configured to implement the functions of the first communication apparatus or the second communication apparatus in the foregoing method embodiments, and therefore can further implement beneficial effects of the foregoing method embodiments. In embodiments of this application, the communication apparatus may be one of the terminals 120a to 120j as shown in FIG. 1, or the network device 110a or 110b as shown in FIG. 1, or a module (for example, a chip or a system on chip) used in the terminal or the network device.

The communication apparatus 1100 includes a transceiver unit 1120, and the transceiver unit 1120 may be configured to receive or send information. The communication apparatus 1100 may further include a processing unit 1110, and the processing unit 1110 may be configured to process instructions or data, to implement a corresponding operation.

It should be further understood that, when the communication apparatus 1100 is a chip configured in (or used in) a communication device, the transceiver unit 1120 in the communication apparatus 1100 may be an input/output interface or a circuit of the chip, and the processing unit 1110 in the communication apparatus 1100 may be a processor in the chip.

Optionally, the communication apparatus 1100 may further include a storage unit 1130. The storage unit 1130 may be configured to store instructions or data. The processing unit 1110 may execute the instructions or the data stored in the storage unit, to cause the communication apparatus to implement a corresponding operation.

The communication apparatus 1100 may be configured to implement functions of the first communication apparatus or the second communication apparatus in the method embodiment shown in FIG. 3.

When the communication apparatus 1100 is configured to implement the function of the first communication apparatus in the method embodiment shown in FIG. 3, the processing unit 1110 is configured to determine, based on first data, a first initial basis vector and a first data space corresponding to the first initial basis vector. The processing unit 1110 is further configured to determine first basis information based on second data that is in the first data and that belongs to the first data space. The processing unit 1110 is further configured to perform data compression on the second data by using the first basis information, to obtain first compressed data. The transceiver unit 1120 is configured to send first information, where the first information indicates the first basis information and the first compressed data.

For more detailed descriptions of the processing unit 1110 and the transceiver unit 1120, refer to related descriptions in the method embodiment shown in FIG. 3.

It should be understood that, the transceiver unit 1120 in the communication apparatus 1100 may be implemented by using a communication interface (for example, a transceiver, a transceiver circuit, an input/output interface, or a pin), and when the communication interface is a transceiver, the transceiver may include a receiver and/or a transmitter. The processing unit 1110 in the communication apparatus 1100 may be implemented by using at least one processor. The processing unit 1110 in the communication apparatus 1100 may alternatively be implemented by using at least one logic circuit. Optionally, the communication apparatus 1100 further includes the storage unit, and the storage unit may be implemented by using a memory.

As shown in FIG. 12, the communication apparatus 1200 includes a processor 1210 and an interface circuit 1220. The processor 1210 and the interface circuit 1220 are coupled to each other. It may be understood that the interface circuit 1220 may be a transceiver or an input/output interface. Optionally, the communication apparatus 1200 may further include a memory 1830, configured to store instructions executed by the processor 1210, input data required by the processor 1210 to run the instructions, or data generated after the processor 1210 runs the instructions.

In an implementation, the memory 1830 may alternatively be integrated into the processor 1210, or may be independent of the processor 1210.

When the communication apparatus 1200 is configured to implement the method shown in FIG. 3, the processor 1210 is configured to implement functions of the processing unit 1110, and the interface circuit 1220 is configured to implement functions of the transceiver unit 1120.

When the communication apparatus is a chip used in a terminal device, the chip in the terminal device may implement functions of the first communication apparatus in the foregoing method embodiments. The chip in the terminal device receives information from another module (for example, a radio frequency module or an antenna) in the terminal device, where the information is sent by a network device to the terminal device. Alternatively, the chip in the terminal device sends information to another module (for example, a radio frequency module or an antenna) in the terminal device, where the information is sent by the terminal device to a network device.

When the communication apparatus is a module used in a network device, the module in the network device may implement functions of the first communication apparatus in the foregoing method embodiments. The module in the network device receives information from another module (for example, a radio frequency module or an antenna) in the network device, where the information is sent by a terminal device to the network device. Alternatively, the module in the network device sends information to another module (for example, a radio frequency module or an antenna) in the network device, where the information is sent by the network device to a terminal device. The module in the network device herein may be a baseband chip of the network device, or may be a DU or another module. The DU herein may be a DU in an open radio access network (open radio access network, O-RAN) architecture.

It may be understood that the processor in embodiments of this application may be a central processing unit (Central Processing Unit, CPU), or may be another general-purpose processor, a digital signal processor (Digital Signal Processor, DSP), an application-specific integrated circuit (Application-Specific Integrated Circuit, ASIC), a field programmable gate array (Field Programmable Gate Array, FPGA) or another programmable logic device, a transistor logic device, a hardware component, or any combination thereof. The general-purpose processor may be a microprocessor or any conventional processor.

The method steps in embodiments of this application may be implemented in hardware, or may be implemented in software instructions that may be executed by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a CD-ROM, or any other form of storage medium well-known in the art. For example, a storage medium is coupled to the processor, so that the processor can read information from the storage medium and write information into the storage medium. The storage medium may alternatively be a component of the processor. The processor and the storage medium may be disposed in an ASIC. In addition, the ASIC may be located in an access network device or a terminal device. The processor and the storage medium may alternatively exist in the access network device or the terminal device as discrete components.

According to the method provided in embodiments of this application, an embodiment of this application further provides a computer program product. The computer program product includes computer program code. When the computer program code is executed by one or more processors, an apparatus including the processor is caused to perform the method shown in FIG. 3.

All or some of the foregoing embodiments may be implemented by using software, hardware, firmware, or any combination thereof. When software is used to implement embodiments, all or some of the foregoing embodiments may be implemented in a form of computer program product. The computer program product includes one or more computer programs or instructions. When the computer programs or instructions are loaded and executed on a computer, all or some of the procedures or functions in embodiments of this application are performed. The computer may be a general-purpose computer, a dedicated computer, a computer network, a network device, user equipment, or another programmable apparatus.

According to the method provided in embodiments of this application, an embodiment of this application further provides a computer-readable storage medium. The computer-readable storage medium stores the foregoing computer programs or instructions. When the computer programs or instructions are run by one or more processors, an apparatus including the processor is caused to perform the method shown in FIG. 3.

The foregoing computer programs or instructions may be stored in the computer-readable storage medium, or may be transmitted from a computer-readable storage medium to another computer-readable storage medium. For example, the computer programs or instructions may be transmitted from a website, computer, server, or data center to another website, computer, server, or data center in a wired or wireless manner. The computer-readable storage medium may be any usable medium accessible by a computer, or a data storage device like a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive. The computer-readable storage medium may be a volatile storage medium or a non-volatile storage medium, or may include two types of storage media: a volatile storage medium and a non-volatile storage medium.

According to the method provided in embodiments of this application, an embodiment of this application further provides a communication system that includes the foregoing one or more first communication apparatuses. The system may further include the foregoing one or more second communication apparatuses.

In the several embodiments provided in this application, it should be understood that the disclosed system, apparatus, and method may be implemented in other manners. For example, the described apparatus is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions.

In embodiments of this application, unless otherwise stated or there is a logic conflict, terms and/or descriptions in different embodiments are consistent and may be mutually referenced, and technical features in different embodiments may be combined into a new embodiment based on an internal logical relationship thereof.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A data compression method, comprising:
determining, based on first data, a first initial basis vector and a first data space corresponding to the first initial basis vector;
determining first basis information based on second data that is in the first data and that belongs to the first data space;
performing data compression on the second data by using the first basis information, to obtain first compressed data; and
sending first information, wherein the first information indicates the first basis information and the first compressed data.

2. The method according to claim 1, wherein determining, based on the first data, the first initial basis vector comprises:
determining first initial basis information based on the first data, wherein a plurality of basis vectors indicated by the first initial basis information comprise the first initial basis vector; and
obtaining the first basis information based on the second data comprises:
adjusting the first initial basis information based on the second data, to obtain the first basis information.

3. The method according to claim 2, wherein a representation coefficient of the second data with respect to the first basis information, is sparser than a representation coefficient of the second data with respect to the first initial basis information.

4. The method according to any one of claims 1 to 3, wherein the first information further indicates a first spatial offset, and the first spatial offset is a spatial offset corresponding to the first data space.

5. The method according to claim 4, wherein performing data compression on the second data by using the first basis information, to obtain the first compressed data comprises:
compressing, by using the first basis information, data obtained by processing the second data based on the first spatial offset, to obtain the first compressed data.

6. The method according to any one of claims 1 to 5, wherein the method further comprises:
determining, based on third data, a second initial basis vector and a second data space corresponding to the second initial basis vector, wherein the third data is data other than the second data in the first data;
determining second basis information based on fourth data that is in the third data and that belongs to the second data space;
performing data compression on the fourth data by using the second basis information, to obtain second compressed data; and
sending second information, wherein the second information indicates the second basis information and the second compressed data; or the second information indicates the second basis information, the second compressed data, and a second spatial offset, and the second spatial offset is a spatial offset corresponding to the second initial basis vector.

7. The method according to claim 6, wherein that the second information indicates the second basis information comprises: the second information comprises differential information between the second basis information and the first basis information.

8. The method according to claim 6 or 7, wherein the differential information comprises angle information, and the angle information indicates an angular difference between the second basis information and the first basis information.

9. The method according to any one of claims 6 to 8, wherein determining, based on the third data, the second initial basis vector comprises:
determining second initial basis information based on the third data, wherein a plurality of basis vectors indicated by the second initial basis information comprise the second initial basis vector; and
obtaining the second basis information based on the fourth data comprises:
adjusting the second initial basis information based on the fourth data, to obtain the second basis information.

10. The method according to claim 9, wherein a representation coefficient of data in the fourth data with respect to the second basis information is sparser than a representation coefficient of the data in the fourth data with respect to the second initial basis information.

11. The method according to claim 9 or 10, wherein determining, based on the third data, the second initial basis information comprises:
adjusting reference basis information based on a target space determined based on the third data, to obtain the second initial basis information.

12. The method according to claim 11, wherein the reference basis information comprises the first basis information, or the reference basis information is predefined.

13. The method according to claim 11 or 12, wherein the reference basis information is determined from a plurality of pieces of predefined candidate basis information, and the first information further indicates the reference basis information.

14. The method according to any one of claims 1 to 5, wherein the method further comprises:
determining, based on third data and the first basis information, maximum differential information between basis information;
determining, based on the maximum differential information and division precision, a plurality of data spaces and a plurality of pieces of basis information corresponding to the plurality of data spaces; and
sending third information, wherein the third information indicates the maximum differential information, and
one piece of basis information among the plurality of pieces of basis information corresponds to one data space among the plurality of data spaces, and the one piece of basis information is used to compress data that is in the third data and that belongs to the one data space.

15. The method according to claim 14, wherein the third information further indicates the division precision, or the division precision is predefined.

16. The method according to claim 14 or 15, wherein the third information further indicates a data space that is in the plurality of data spaces and that comprises and/or does not comprise data in the third data.

17. The method according to claim 15 or 16, wherein the plurality of data spaces comprise M data spaces, M is a positive integer, the M data spaces each comprise the data in the third data, and the third information further comprises compressed data obtained by separately compressing data in corresponding data spaces based on M pieces of basis information corresponding to the M data spaces.

18. A communication apparatus, comprising:
a processing unit, configured to determine, based on first data, a first initial basis vector and a first data space corresponding to the first initial basis vector, wherein
the processing unit is further configured to determine first basis information based on second data that is in the first data and that belongs to the first data space; and
the processing unit is further configured to perform data compression on the second data by using the first basis information, to obtain first compressed data; and
a transceiver unit, configured to send first information, wherein the first information indicates the first basis information and the first compressed data.

19. The apparatus according to claim 18, wherein the processing unit is specifically configured to determine first initial basis information based on the first data, wherein a plurality of basis vectors indicated by the first initial basis information comprise the first initial basis vector; and
the processing unit is specifically configured to adjust the first initial basis information based on the second data, to obtain the first basis information.

20. The apparatus according to claim 19, wherein a representation coefficient of the second data with respect to the first basis information, is sparser than a representation coefficient of the second data with respect to the first initial basis information.

21. The apparatus according to any one of claims 18 to 20, wherein the first information further indicates a first spatial offset, and the first spatial offset is a spatial offset corresponding to the first data space.

22. The apparatus according to claim 21, wherein the processing unit is specifically configured to compress, by using the first basis information, data obtained by processing the second data based on the first spatial offset, to obtain the first compressed data.

23. The apparatus according to any one of claims 18 to 22, wherein
the processing unit is further configured to determine, based on third data, a second initial basis vector and a second data space corresponding to the second initial basis vector, wherein the third data is data other than the second data in the first data;
the processing unit is further configured to determine second basis information based on fourth data that is in the third data and that belongs to the second data space;
the processing unit is further configured to perform data compression on the fourth data by using the second basis information, to obtain second compressed data; and
the transceiver unit is further configured to send second information, wherein the second information indicates the second basis information and the second compressed data; or the second information indicates the second basis information, the second compressed data, and a second spatial offset, and the second spatial offset is a spatial offset corresponding to the second initial basis vector.

24. The apparatus according to claim 23, wherein the processing unit is specifically configured to determine second initial basis information based on the third data, wherein a plurality of basis vectors indicated by the second initial basis information comprise the second initial basis vector; and
the processing unit is specifically configured to adjust the second initial basis information based on the fourth data, to obtain the second basis information.

25. The apparatus according to claim 24, wherein a representation coefficient of data in the fourth data with respect to the second basis information is sparser than a representation coefficient of the data in the fourth data with respect to the second initial basis information.

26. The apparatus according to claim 24 or 25, wherein the processing unit is specifically configured to adjust reference basis information based on a target space determined based on the third data, to obtain the second initial basis information.

27. The apparatus according to any one of claims 18 to 21, wherein
the processing unit is further configured to determine, based on third data and the first basis information, maximum differential information between basis information;
the processing unit is further configured to determine, based on the maximum differential information and division precision, a plurality of data spaces and a plurality of pieces of basis information corresponding to the plurality of data spaces; and
the transceiver unit is further configured to send third information, wherein the third information indicates the maximum differential information, and
one piece of basis information among the plurality of pieces of basis information corresponds to one data space among the plurality of data spaces, and the one piece of basis information is used to compress data that is in the third data and that belongs to the one data space.

28. The apparatus according to claim 27, wherein the third information further indicates a data space that is in the plurality of data spaces and that comprises and/or does not comprise data in the third data.

29. A communication apparatus, comprising a processor, wherein the processor is coupled to a memory, and the processor is configured to perform the method according to any one of claims 1 to 17.

30. A computer-readable storage medium, storing instructions, wherein when the instructions are run on a computer, the computer is caused to perform the method according to any one of claims 1 to 17.

31. A computer program product, wherein the computer program product comprises a computer program, and when the computer program is run, a computer is caused to perform the method according to any one of claims 1 to 17.
